# EUROPEAN PATENT APPLICATION

(11) **EP 4 832 698 A1**
(43) Date of publication of application: **28.10.2026**
(21) Application number: 25824682.6
(22) Date of filing: 29.04.2025
(51) Int. Cl.: H10F 77/14

(54) **BACK-CONTACT SOLAR CELL, BATTERY MODULE AND PHOTOVOLTAIC SYSTEM**

(30) Priority: 24.06.2024 CN 202410822620
(71) Applicant: Zhuhai Fushan Aiko Solar Energy Technology Co., Ltd., FushanIndustrial Park, Doumen District Zhuhai Guangdong 519000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Zhejiang Aiko Solar Energy Technology Co., Ltd., Yiwu, Jinhua Zhejiang 322000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, Shengli, Jinhua, Zhejiang 322000 (CN); CHEN, Hui, Jinhua, Zhejiang 322000 (CN)
(74) Representative: Cohausz & Florack
(86) International application number: PCT/CN2025/092155
(87) International publication number: WO 2026/001293

(57) **Abstract**

The present disclosure is applicable to the technical field of solar cells, and provides a back contact solar cell, a battery module, and a photovoltaic system. The back contact solar cell comprises: a silicon substrate having a back surface and a front surface arranged oppositely; a P-type doped polysilicon layer located in a first region on the back surface of the silicon substrate; an N-type doped polysilicon layer located in a second region on the back surface of the silicon substrate, wherein the first region is different from the second region; a P-type doped internal diffusion layer formed inside the silicon substrate and arranged close to the P-type doped polysilicon layer; and an N-type doped internal diffusion layer formed inside the silicon substrate and arranged close to the N-type doped polysilicon layer; wherein a depth of the P-type doped internal diffusion layer is greater than a depth of the N-type doped internal diffusion layer. As to the back contact solar cell provided in the present disclosure, the depth of the P-type doped internal diffusion layer is set to be greater than the depth of the N-type doped internal diffusion layer, and the emitter current collection efficiency of the back contact solar cell can be improved by increasing the depth of the P-type doped internal diffusion layer, and further the cell efficiency is improved.

## Description

### Cross-Reference to Related Application

The present application claims the priority of the Chinese patent application filed with the Chinese Patent Office on June 24, 2024, with an application number of 202410822620.7 and entitled "Back Contact Solar Cell, Battery Module and Photovoltaic System", the contents of which are incorporated herein by reference in its entirety.

### Technical Field

The present disclosure relates to the technical field of solar cells, in particular to a back contact solar cell, a battery module, and a photovoltaic system.

### Background

As a sustainable clean energy source, solar cell power generation utilizes the photovoltaic effect of a semiconductor p-n junction to convert sunlight into electricity, while the conversion efficiency is an important indicator of the performance of solar cells. As to IBC (interdigitated back contact) solar cells, also known as interdigitated back contact cells, their positive and negative electrodes are designed on aback surface of the cell, thereby completely avoiding a front surface from being blocked by metal grid lines, and eliminating an optical loss caused by blocking of the metal grid lines. Meanwhile, the width of an electrode can be designed to be greater than the existing width, soseries resistance loss is reduced, and conversion efficiency of cells is significantly improved. In addition, since no electrode is designed on a front surface of the cell, the product appearance is more beautiful and is suitable for a variety of application scenarios.

In the prior art, interdigitated P regions and N regions are formed on the back surface of the back contact solar cell. Generally, when a P-type doped polysilicon layer in the P region and an N-type doped polysilicon layer in the N region are prepared, the P-type doped polysilicon layer will form a P-type doped internal diffusion layer inside a silicon wafer, and the N-type doped polysilicon layer will form an N-type doped internal diffusion layer inside the silicon wafer. For ease of processing, the depth of the P-type doped internal diffusion layer is usually approximately equal to the depth of the N-type doped internal diffusion layer, thereby resulting in a low efficiency in collecting emitter current, and further influencing the cell efficiency.

### Summary

The present disclosure provides a back contact solar cell, aiming at solving the following problem: as to the back contact solar cell in the prior art, the depth of the P-type doped internal diffusion layer is equal to the depth of the N-type doped internal diffusion layer, thereby resulting in a low efficiency in collecting emitter current, and further influencing the cell efficiency.

The present disclosure is implemented by providing aback contact solar cell, and the back contact solar cell includes:
asilicon substrate having a back surface and a front surface arranged oppositely;
a P-type doped polysilicon layer located in a first region on the back surface of the silicon substrate;
an N-type doped polysilicon layer located in a second region on the back surface of the silicon substrate, wherein the first region is different from the second region;
a P-type doped internal diffusion layer formed inside the silicon substrate and arranged close to the P-type doped polysilicon layer; and
an N-type doped internal diffusion layer formed inside the silicon substrate and arranged close to the N-type doped polysilicon layer;
wherein a depth of the P-type doped internal diffusion layer is greater than a depth of the N-type doped internal diffusion layer.

In some embodiments, a ratio of the depth of the P-type doped internal diffusion layer to the depth of the N-type doped internal diffusion layer ranges from 1 to 4, and is not equal to 1.

In some embodiments, a ratio of the depth of the P-type doped internal diffusion layer to the depth of the N-type doped internal diffusion layer ranges from 1 to 2, and is not equal to 1.

In some embodiments, the depth of the P-type doped internal diffusion layer ranges from 30 nm to 800 nm; and the depth of the N-type doped internal diffusion layer ranges from 10 nm to 600 nm.

In some embodiments, a width of the P-type doped internal diffusion layer is greater than a width of the N-type doped internal diffusion layer.

In some embodiments, a ratio of the width of the P-type doped internal diffusion layer to the width of the N-type doped internal diffusion layer ranges from 1 to 2, and is not equal to 1.

In some embodiments, a volume of the P-type doped internal diffusion layer is greater than a volume of the N-type doped internal diffusion layer.

In some embodiments, a ratio of the volume of the P-type doped internal diffusion layer to the volume of the N-type doped internal diffusion layer ranges from 1 to 2, and is not equal to 1.

In some embodiments, a thickness of the N-type doped polysilicon layer is greater than a thickness of the P-type doped polysilicon layer.

In some embodiments, a ratio of the thickness of the N-type doped polysilicon layer to the thickness of the P-type doped polysilicon layer ranges from 1 to 2, and is not equal to 1.

In some embodiments, a ratio of the thickness of the N-type doped polysilicon layer to the thickness of the P-type doped polysilicon layer ranges from 1 to 1.5, and is not equal to 1.

In some embodiments, the back contact solar cell further includes:
a first passivation layer arranged between the P-type doped internal diffusion layer and the P-type doped polysilicon layer, wherein the first passivation layer contains a P-type dopant; and
a second passivation layer arranged between the N-type doped internal diffusion layer and the N-type doped polysilicon layer, wherein the second passivation layer contains an N-type dopant;
wherein a doping concentration of the P-type dopant in the first passivation layer is lower than a doping concentration of the N-type dopant in the second passivation layer.

In some embodiments, a doping concentration of a P-type dopant in the P-type doped internal diffusion layer is lower than a doping concentration of a N-type dopant in the N-type doped internal diffusion layer.

The present disclosure further provides a battery module including the above back contact solar cell.

The present disclosure further provides a photovoltaic system including the above battery module.

As to the back contact solar cell provided in the embodiments of the present disclosure, the depth of the P-type doped internal diffusion layer is set to be greater than the depth of the N-type doped internal diffusion layer, and under a premise of unchanged depth of the N-type doped internal diffusion layer and under a premise of not influencing the requirement of the depth of the N-type doped internal diffusion layer, the emitter current collection efficiency of the back contact solar cell can be improved by increasing the depth of the P-type doped internal diffusion layer, and further the cell efficiency is improved.

### Brief Description of the Drawings

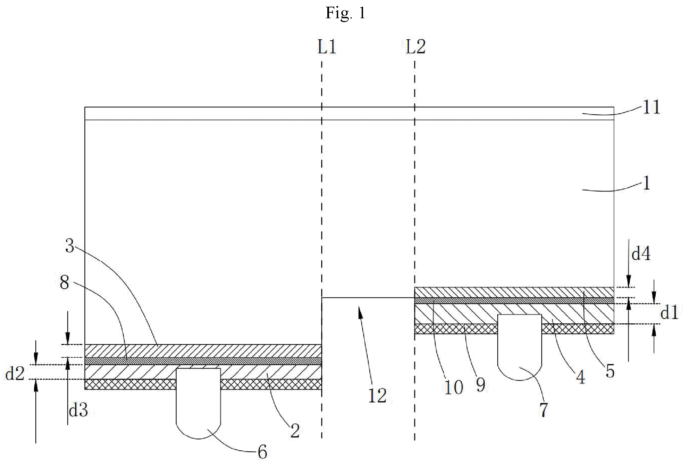

Fig. 1 is a schematic diagram of a back contact solar cell provided in an embodiment of the present disclosure.

### Detailed Description of the Embodiments

To make the objectives, technical solutions, and advantages of the present disclosure clearer, the present disclosure will be further described in detail below with reference to the accompanying drawings and embodiments. It should be understood that specific embodiments described herein are merely used to explain the present disclosure, rather than limiting the present disclosure.

As to the back contact solar cell provided in the embodiments of the present disclosure, the depth of the P-type doped internal diffusion layer is set to be greater than the depth of the N-type doped internal diffusion layer, and under a premise of unchanged depth of the N-type doped internal diffusion layer and under a premise of not influencing the requirement of the depth of the N-type doped internal diffusion layer, the emitter current collection efficiency of the back contact solar cell can be improved by increasing the depth of the P-type doped internal diffusion layer, and further the cell efficiency is improved.

Please refer to Fig. 1. The embodiment of the present disclosure provides a back contact solar cell, and the back contact solar cell includes:
a silicon substrate 1 having a back surface and a front surface arranged oppositely;
a P-type doped polysilicon layer 2 located in a first region on the back surface of the silicon substrate 1;
an N-type doped polysilicon layer 4 located in a second region on the back surface of the silicon substrate 1, wherein the first region is different from the second region;
a P-type doped internal diffusion layer 3 formed inside the silicon substrate 1 and arranged close to the P-type doped polysilicon layer 2; and
an N-type doped internal diffusion layer 5 formed inside the silicon substrate 1 and arranged close to the N-type doped polysilicon layer 4;
wherein the depth d3 of the P-type doped internal diffusion layer 3 is greater than the depth d4 of the N-type doped internal diffusion layer 5.

As shown in Fig. 1, the back surface of the silicon substrate 1 is a lower side, and the front surface is an upper side. A dashed line L1 and a dashed line L2 are only for distinguishing the first region from the second region, and do not actually exist in the back contact solar cell. Referring to Fig. 1, the region on a left side of the dashed line L1 is a first region, and the region on a right side of the dashed line L2 is a second region. The first region and the second region are different regions respectively. The P-type doped polysilicon layer 2 is located in the first region on the back surface of the silicon substrate 1, and the N-type doped polysilicon layer 4 is located in the second region on the back surface of the silicon substrate 1; the P-type doped polysilicon layer 2 is located in the region on the left side of the dashed line L1 on the back surface of the silicon substrate 1; and the N-type doped polysilicon layer 4 is located in the region on the right side of the dashed line L2 on a first side of the silicon substrate 1.

In the embodiment of the present disclosure, the silicon substrate 1 may be an N-type silicon substrate or a P-type silicon substrate.

In the embodiment of the present disclosure, the depth d3 of the P-type doped internal diffusion layer 3 is a distance from the back surface of the silicon substrate 1 to a bottom surface of the P-type doped internal diffusion layer 3, and the depth d4 of the N-type doped internal diffusion layer 5 is a distance from the back surface of the silicon substrate 1 to a bottom surface of the N-type doped internal diffusion layer 5. As to the back contact solar cell, the depth d3 of the P-type doped internal diffusion layer 3 is set to be greater than the depth d4 of the N-type doped internal diffusion layer 5, and under a premise of unchanged depth of the N-type doped internal diffusion layer 5 and under a premise of not influencing the depth of the N-type doped internal diffusion layer 5, the emitter current collection efficiency of the back contact solar cell can be improved by increasing the depth of the P-type doped internal diffusion layer3, and further the cell efficiency is improved.

In practical applications, specifically, through adjusting heat treatment temperature and time during the preparation of the P-type doped polysilicon layer 2 and the N-type doped polysilicon layer 4, the depth d3 of the P-type doped internal diffusion layer 3 can be made greater than the depth d4 of the N-type doped internal diffusion layer 5 after the P-type doped polysilicon layer 2 and the N-type doped polysilicon layer 4 are prepared, so as to effectively improve the cell efficiency. For example, by controlling the heat treatment temperature of the P-type doped polysilicon layer 2 to be higher than the heat treatment temperature of the N-type doped polysilicon layer 4, or by controlling the heat treatment time of the P-type doped polysilicon layer 2 to be longer than the heat treatment time of the N-type doped polysilicon layer 4, the depth d3 of the P-type doped internal diffusion layer 3 can be made greater than the depth d4 of the N-type doped internal diffusion layer 5. Alternatively, by controlling the heat treatment temperature of the P-type doped polysilicon layer 2 to be higher than the heat treatment temperature of the N-type doped polysilicon layer 4, and by controlling the heat treatment time of the P-type doped polysilicon layer 2 to be longer than the heat treatment time of the N-type doped polysilicon layer 4, the depth d3 of the P-type doped internal diffusion layer 3 can also be made greater than the depth d4 of the N-type doped internal diffusion layer 5.

As an embodiment of the present disclosure, the ratio of the depth d3 of the P-type doped internal diffusion layer 3 to the depth d4 of the N-type doped internal diffusion layer 5 ranges from 1 to 4, and is not equal to 1.

In this embodiment, the ratio of the depth d3 of the P-type doped internal diffusion layer 3 to the depth d4 of the N-type doped internal diffusion layer 5 is set to be greater than 1 and less than or equal to 4. This configuration of the ratio not only improves the emitter current collection efficiency of the back contact solar cell and improves the cell efficiency, but also facilitates the control of a depth difference between the P-type doped internal diffusion layer 3 and the N-type doped internal diffusion layer 5, and facilitates the processing of the P-type doped polysilicon layer 2 and the N-type doped polysilicon layer 4.

For example, the ratio of the depth d3 of the P-type doped internal diffusion layer 3 to the depth d4 of the N-type doped internal diffusion layer 5 can be:
1.01, 1.08, 1.1, 1.15, 1.2, 1.25, 1.3, 1.35, 1.4, 1.45, 1.5, 1.55, 1.6, 1.65, 1.7, 1.75, 1.8, 1.85, 1.9, 1.92, 2.0, 2.2, 2.3, 2.5, 2.6, 2.9, 3.0, 3.5, 3.7, 3.8, 3.9, or 4.0.

As an embodiment of the present disclosure, the ratio of the depth d3 of the P-type doped internal diffusion layer 3 to the depth d4 of the N-type doped internal diffusion layer 5 ranges from 1 to 2.

In this embodiment, the ratio of the depth d3 of the P-type doped internal diffusion layer 3 to the depth d4 of the N-type doped internal diffusion layer 5 is set to be greater than 1 and less than or equal to 2,andthe depth d3 of the P-type doped internal diffusion layer 3 and the depth d4 of the N-type doped internal diffusion layer 5 fall within a more appropriate range, thereby not only improving the emitter current collection efficiency of the back contact solar cell and improving the cell efficiency, but also facilitating the processing of the P-type doped polysilicon layer 2 and the N-type doped polysilicon layer 4.

As an embodiment of the present disclosure, the depth d3 of the P-type doped internal diffusion layer 3 ranges from 30 nm to 800 nm, while the depth d4 of the N-type doped internal diffusion layer 5 ranges from 10 nm to 600 nm.

For example, the depth d3 of the P-type doped internal diffusion layer 3 can be30 nm, 50 nm, 80 nm, 100 nm, 150 nm, 180 nm, 220 nm, 250 nm, 280 nm, 300 nm, 350 nm, 400 nm, 450 nm, 500 nm, 560 nm, 600 nm, 650 nm, 680 nm, 700 nm, 720 nm, 780 nm, or 800 nm.

For example, the depth d4 of the N-type doped internal diffusion layer 5 can be10 nm, 50 nm, 100 nm, 150 nm, 200 nm, 250 nm, 300 nm, 240 nm, 350 nm, 400 nm, 450 nm, 500 nm, 550 nm, or 600 nm.

As an embodiment of the present disclosure, the width of the P-type doped internal diffusion layer 3 is greater than the width of the N-type doped internal diffusion layer 5.

In this embodiment, the width of the P-type doped internal diffusion layer 3 is greater than the width of the N-type doped internal diffusion layer 5, such that the area of the P-type doped internal diffusion layer 3 is larger than the area of the N-type doped internal diffusion layer 5, and the area of the P-type doped internal diffusion layer 3can be increased, and further the emitter current collection efficiency of the back contact solar cell is improved, and the cell efficiency is improved. Specifically, the width of the P-type doped polysilicon layer 2 can be increased to expand the width of the P-type doped internal diffusion layer 3 formed by the diffusion of the P-type doped polysilicon layer 2into the silicon substrate 1, i.e., the width of the P-type doped polysilicon layer 2 is greater than the width of the N-type doped polysilicon layer 4.

As an embodiment of the present disclosure, the ratio of the width of the P-type doped internal diffusion layer 3 to the width of the N-type doped internal diffusion layer 5 ranges from 1 to 2, and is not equal to 1. This configuration of the ratio not only ensures that the width of the P-type doped internal diffusion layer 3 and the width of the N-type doped internal diffusion layer 5 are kept in an appropriate range to maintain a higher cell efficiency, but also facilitates the preparation of the P-type doped polysilicon layer 2 and the N-type doped polysilicon layer 4, wherein the width of the P-type doped internal diffusion layer 3 corresponds to the width of the P-type doped polysilicon layer 2, and the width of the N-type doped internal diffusion layer 5 corresponds to the width of the N-type doped polysilicon layer 4. The width of the P-type doped internal diffusion layer 3can be accordingly changed by adjusting the width of the P-type doped polysilicon layer 2, the width of the N-type doped internal diffusion layer 5 can be accordingly changed by adjusting the width of the N-type doped polysilicon layer 4, and the widths of the P-type doped polysilicon layer 2 and the N-type doped polysilicon layer 4 can be set flexibly according to actual situations.

As an embodiment of the present disclosure, the volume of the P-type doped internal diffusion layer 3 is greater than the volume of the N-type doped internal diffusion layer 5.

In this embodiment, the volume of the P-type doped internal diffusion layer 3 is greater than the volume of the N-type doped internal diffusion layer 5, and the volume of the P-type doped internal diffusion layer 3 is greater than the volume of the N-type doped internal diffusion layer 5, such that the volume of the P-type doped internal diffusion layer 3can be increased, and further the emitter current collection efficiency of the back contact solar cell is improved, and the cell efficiency is improved. Specifically, the width or depth of the P-type doped polysilicon layer 2 can be increased, so as to increase the volume of the P-type doped internal diffusion layer 3 formed by the diffusion of the P-type doped polysilicon layer 2 into the silicon substrate 1, that is, the volume of the P-type doped polysilicon layer 2 is greater than the volume of the N-type doped polysilicon layer 4.

As an embodiment of the present disclosure, the ratio of the volume of the P-type doped internal diffusion layer 3 to the volume of the N-type doped internal diffusion layer 5 ranges from 1 to 2, and is not equal to 1.

In this embodiment, the ratio of the volume of the P-type doped internal diffusion layer 3 to the volume of the N-type doped internal diffusion layer 5 is greater than 1 and less than or equal to 2. This configuration of the ratio not only ensures that the volume of the P-type doped internal diffusion layer 3 and the volume of the N-type doped internal diffusion layer 5are kept in an appropriate range to maintain a higher cell efficiency, but also facilitates the preparation of the P-type doped polysilicon layer 2 and the N-type doped polysilicon layer 4, wherein the width of the P-type doped internal diffusion layer 3 corresponds to the width of the P-type doped polysilicon layer 2, the width of the N-type doped internal diffusion layer 5 corresponds to the width of the N-type doped polysilicon layer 4, the depth d3 of the P-type doped internal diffusion layer 3 corresponds to the heat treatment temperature and the heat treatment time for preparing the P-type doped polysilicon layer 2, and the depth d4 of the N-type doped internal diffusion layer 5 corresponds to the heat treatment temperature and the heat treatment time for preparing the N-type doped polysilicon layer 4. Therefore, under a premise that the depth d3 of the P-type doped internal diffusion layer 3 is greater than the depth d4 of the N-type doped internal diffusion layer 5, the width of the P-type doped polysilicon layer 2 is set to be greater than or equal to the width of the N-type doped polysilicon layer 4, and the volume of the P-type doped internal diffusion layer 3 is greater than the volume of the N-type doped internal diffusion layer 5.

As an embodiment of the present disclosure, the back contact solar cell further includes:
a first passivation layer 8 arranged between the P-type doped internal diffusion layer 3 and the P-type doped polysilicon layer 2, wherein the first passivation layer 8 contains a P-type dopant; and
a second passivation layer 10 arranged between the N-type doped internal diffusion layer 5 and the N-type doped polysilicon layer 4, wherein the second passivation layer 10 contains an N-type dopant;
wherein the doping concentration of the P-type dopant in the first passivation layer 8 is lower than the doping concentration of the N-type dopant in the second passivation layer 10.

In this embodiment, the first passivation layer 8 is specifically a silicon dioxide passivation layer. By arranging the first passivation layer 8 and the second passivation layer 10, and making the doping concentration of the P-type dopant in the first passivation layer 8 be lower than the doping concentration of the N-type dopant in the second passivation layer 10, the gettering effect of the N region is enhanced, and the cell efficiency is improved.

As an embodiment of the present disclosure, the doping concentration of the P-type dopant in the P-type doped internal diffusion layer 3 is lower than the doping concentration of the N-type dopant in the N-type doped internal diffusion layer 5, thereby further enhancing the gettering effect of the N region.

As an embodiment of the present disclosure, the thickness of the N-type doped polysilicon layer 4 is greater than the thickness of the P-type doped polysilicon layer 2.

In this embodiment, under a premise that the thickness d1 of the N-type doped polysilicon layer 4 remains unchanged and the effect of the N-type doped polysilicon layer 4 is not influenced, the thickness d2 of the P-type doped polysilicon layer 2 is reduced, so as to reduce the etching difficulty of the P-type doped polysilicon, reduce difficulty of a patterning process, and facilitate the patterning process of the P-type doped polysilicon. Moreover, the thickness d2 of the P-type doped polysilicon layer 2 is reduced, thereby reducing the difficulty in boron diffusion, being beneficial to a boron diffusion process, and facilitating the preparation of the P-type doped polysilicon layer 2 with a higher concentration; furthermore, the thickness d1 of the N-type doped polysilicon layer 4 is greater than the thickness d2 of the P-type doped polysilicon layer 2, and the N-type doped polysilicon is thicker than the P-type doped polysilicon layer 2, thereby enhancing the passivation effect and improving the cell efficiency. In addition, as to the preparation of the back contact solar cell, the P-type doped polysilicon layer 2 is first prepared on the entire surface and then the N-type doped polysilicon layer 4 is prepared, and the P-type doped polysilicon in the N region needs to be etched away before the N-type doped polysilicon layer 4 is prepared. Therefore, in this embodiment, if the thickness of the P-type doped polysilicon layer 2 is reduced, the etching difficulty of the P-type doped polysilicon is reduced, such that the P-type doped polysilicon in the N region can be easily completely removed, and the preparation of the N-type doped polysilicon layer 4 is facilitated.

As an embodiment of the present disclosure, the ratio of the thickness d1 of the N-type doped polysilicon layer 4 to the thickness d2 of the P-type doped polysilicon layer 2 ranges from 1 to 2, and is not equal to 1.

In this embodiment, the ratio of the thickness d1 of the N-type doped polysilicon layer 4 to the thickness d2 of the P-type doped polysilicon layer 2 is greater than 1 and less than or equal to 2. This configuration of the ratio not only reduces the etching difficulty of the P-type doped polysilicon layer 2 and facilitates the patterning process of the P-type doped polysilicon layer 2, but also is beneficial to the boron diffusion process, reduces difficulty in boron diffusion, and facilitates the preparation of the P-type doped polysilicon layer 2 with a higher concentration. More importantly, excessive metallization damage or excessive contact resistance of the P-type doped polysilicon layer 2 can be prevented, and the cell efficiency loss is reduced.

For example, the ratio of the thickness d1 of the N-type doped polysilicon layer 4 to the thickness d2 of the P-type doped polysilicon layer 2 can be:
1.01, 1.05, 1.1, 1.15, 1.2, 1.25, 1.3, 1.35, 1.4, 1.45, 1.5, 1.55, 1.6, 1.65, 1.7, 1.75, 1.8, 1.85, 1.9, 1.92, or 2.

Optionally, when the ratio of d1 to d2 ranges from 1 to 2, the thickness d1 of the N-type doped polysilicon layer 4 ranges from 100nm to 600nm, and the thickness d2 of the P-type doped polysilicon layer 2 can range from 50nm to 300nm. When d1 and d2 are within the above ranges, the P-type doped polysilicon layer 2 and the N-type doped polysilicon layer 4 both easily achieve good doping effects and have good passivation effects, while ensuring less metallization damage and lower contact resistance at a relatively low cost. In addition, the etching difficulty of the P-type doped polysilicon is reduced, thereby facilitating the patterning process of the P-type doped polysilicon, being beneficial to the boron diffusion process, reducing difficulty in boron diffusion, and facilitating the preparation of the P-type doped polysilicon layer 2 with a high concentration.

For example, the thickness d1 of the N-type doped polysilicon layer 4 can be 100 nm, 105 nm, 135 nm, 145 nm, 173 nm, 185 nm, 200 nm, 240 nm, 285 nm, 300 nm, 301 nm, 342 nm, 367 nm, 370 nm, 420 nm, 456 nm, 482 nm, 500 nm, 550 nm, 570 nm, 590 nm, or 600 nm.

For example, the thickness d2 of the P-type doped polysilicon layer 2 can be 50 nm, 45 nm, 52 nm, 60 nm, 66.7 nm, 73 nm, 81 nm, 90 nm, 92 nm, 100 nm, 112 nm, 133 nm, 144 nm, 175 nm, 190 nm, 211 nm, 243 nm, 270 nm, 282 nm, 296 nm, or 300 nm.

As an embodiment of the present disclosure, the ratio of the thickness d1 of the N-type doped polysilicon layer 4 to the thickness d2 of the P-type doped polysilicon layer 2 ranges from 1 to 1.5, and is not equal to 1.

In this embodiment, the ratio of the thickness d1 of the N-type doped polysilicon layer 4 to the thickness d2 of the P-type doped polysilicon layer 2 is greater than 1 and less than or equal to 1.5.This configuration of the ratio not only reduces the thickness d1 of the N-type doped polysilicon layer 4 and the processing cost of the P-type doped polysilicon layer 2, and facilitates the patterning process of the P-type doped polysilicon, but also is beneficial to the boron diffusion process and the preparation of the P-type doped polysilicon layer 2 with a higher concentration. Moreover, excessive metallization damage or excessive contact resistance of the P-type doped polysilicon layer 2 can be prevented, and the cell efficiency loss is reduced.

As an embodiment of the present disclosure, the back contact solar cell further includes:
a first metal electrode 6 located in the first region on the back surface of the silicon substrate 1 and in contact with the P-type doped polysilicon layer 2; and
a second metal electrode 7 located in the second region on the back surface of the silicon substrate 1 and in contact with the N-type doped polysilicon layer 42.

In this embodiment, the depth of a metal crystal of the metal electrode penetrating into the P-type doped polysilicon layer 2 and the N-type doped polysilicon layer 4 can be controlled by controlling the temperature and time during a metallization process. In some embodiments, the depth of the metal crystal of the first metal electrode 6 penetrating into the P-type doped polysilicon layer 2 is greater than the depth of the metal crystal of the second metal electrode 7 penetrating into the N-type doped polysilicon layer 4, then the contact effect between the first metal electrode 6 and the P-type doped polysilicon layer 2 is enhanced, and the cell conversion efficiency is improved.

As an embodiment of the present disclosure, the back contact solar cell further includes a back surface passivation film layer 9 located on the surfaces of the P-type doped polysilicon layer 2 and the N-type doped polysilicon layer 4, to further enhance the conversion efficiency of the back contact solar cell.

As an embodiment of the present disclosure, the silicon substrate 1 is further provided with a trench 12 located between the P-type doped polysilicon layer 2 and the N-type doped polysilicon layer 4. The P-type doped polysilicon layer 2 is physically isolated from the N-type doped polysilicon layer 4 by the trench 12, to further improve the isolation effect between the P-type doped polysilicon layer 2 and the N-type doped polysilicon layer 4, and further reduce the risk of short circuit or leakage. The width of the trench can be flexibly set according to actual needs, which is not limited herein.

As an embodiment of the present disclosure, the front surface of the silicon substrate 1 has a textured structure (not shown in the figure), to achieve a favorable light trapping effect and improve the conversion efficiency of the back contact solar cell. In addition, a front surface passivation anti-reflection film layer 11 can be further arranged on the front surface of the back contact solar cell, to further improve the conversion efficiency of the back contact solar cell.

The embodiments of the present disclosure further provide a battery module, and the battery module includes the back contact solar cell described in the above embodiments. It should be noted that the battery module has the same or similar beneficial effects as the back contact solar cell, and the relevant parts between the two can be referred to each other. To avoid repetition, details are not repeated herein.

The embodiments of the present disclosure also provide a photovoltaic system, and the photovoltaic system includes the battery module described in the above embodiments. It should be noted that the battery module has the same or similar beneficial effects as the back contact solar cell, and the relevant parts between the two can be referred to each other. To avoid repetition, details are not repeated herein.

As to the back contact solar cell provided in the embodiments of the present disclosure, the depth of the P-type doped internal diffusion layer is set to be greater than the depth of the N-type doped internal diffusion layer, and under a premise of unchanged depth of the N-type doped internal diffusion layer and under a premise of not influencing the requirement of the depth of the N-type doped internal diffusion layer, the emitter current collection efficiency of the back contact solar cell can be improved by increasing the depth of the P-type doped internal diffusion layer, and further the cell efficiency is improved.

The above are merely preferred embodiments of the present disclosure and are not intended to limit the present disclosure. Any modifications, equivalent substitutions, improvements and the like made within the spirit and principles of the present disclosure shall be included in the protection scope of the present disclosure.

## Claims

1. A back contact solar cell, comprising:
a silicon substrate having a back surface and a front surface arranged oppositely;
a P-type doped polysilicon layer located in a first region on the back surface of the silicon substrate;
an N-type doped polysilicon layer located in a second region on the back surface of the silicon substrate, wherein the first region is different from the second region;
a P-type doped internal diffusion layer formed inside the silicon substrate and arranged close to the P-type doped polysilicon layer; and
an N-type doped internal diffusion layer formed inside the silicon substrate and arranged close to the N-type doped polysilicon layer;
wherein a depth of the P-type doped internal diffusion layer is greater than a depth of the N-type doped internal diffusion layer.

2. The back contact solar cell according to claim 1, wherein a ratio of the depth of the P-type doped internal diffusion layer to the depth of the N-type doped internal diffusion layer ranges from 1 to 4, and is not equal to 1.

3. The back contact solar cell according to claim 1, wherein a ratio of the depth of the P-type doped internal diffusion layer to the depth of the N-type doped internal diffusion layer ranges from 1 to 2, and is not equal to 1.

4. The back contact solar cell according to claim 1, wherein the depth of the P-type doped internal diffusion layer ranges from 30 nm to 800 nm; and the depth of the N-type doped internal diffusion layer ranges from 10 nm to 600 nm.

5. The back contact solar cell according to claim 1, wherein a width of the P-type doped internal diffusion layer is greater than a width of the N-type doped internal diffusion layer.

6. The back contact solar cell according to claim 5, wherein a ratio of the width of the P-type doped internal diffusion layer to the width of the N-type doped internal diffusion layer ranges from 1 to 2, and is not equal to 1.

7. The back contact solar cell according to claim 1, wherein a volume of the P-type doped internal diffusion layer is greater than a volume of the N-type doped internal diffusion layer.

8. The back contact solar cell according to claim 7, wherein a ratio of the volume of the P-type doped internal diffusion layer to the volume of the N-type doped internal diffusion layer ranges from 1 to 2, and is not equal to 1.

9. The back contact solar cell according to claim 1, wherein a thickness of the N-type doped polysilicon layer is greater than a thickness of the P-type doped polysilicon layer.

10. The back contact solar cell according to claim 9, wherein a ratio of the thickness of the N-type doped polysilicon layer to the thickness of the P-type doped polysilicon layer ranges from 1 to 2, and is not equal to 1.

11. The back contact solar cell according to claim 9, wherein a ratio of the thickness of the N-type doped polysilicon layer to the thickness of the P-type doped polysilicon layer ranges from 1 to 1.5, and is not equal to 1.

12. The back contact solar cell according to claim 1, further comprising:
a first passivation layer arranged between the P-type doped internal diffusion layer and the P-type doped polysilicon layer, wherein the first passivation layer contains a P-type dopant; and
a second passivation layer arranged between the N-type doped internal diffusion layer and the N-type doped polysilicon layer, wherein the second passivation layer contains an N-type dopant;
wherein a doping concentration of the P-type dopant in the first passivation layer is lower than a doping concentration of the N-type dopant in the second passivation layer.

13. The back contact solar cell according to claim 1, wherein a doping concentration of a P-type dopant in the P-type doped internal diffusion layer is lower than a doping concentration of a N-type dopant in the N-type doped internal diffusion layer.

14. A battery module, comprising the back contact solar cell of any one of claims 1-13.

15. A photovoltaic system, comprising the battery module of claim 14.
